# EUROPÄISCHE PATENTANMELDUNG

(11) **EP 2 194 440 A2**
(43) Veröffentlichungstag der Anmeldung: **09.06.2010**
(21) Anmeldenummer: 09172687.7
(22) Anmeldetag: 09.10.2009
(51) Int. Cl.: G06F 1/20

(54) **Verfahren und Anordnung zur Kühlung von wärmeentwickelnden Computerkomponenten**

(30) Priorität: 05.12.2008 DE 102008060777
(71) Anmelder: Sinitec Vertriebsgesellschaft mbH, 80807 München (DE)
(72) Erfinder: Riebel, Michael, 86438 Kissing (DE)
(74) Vertreter: Epping, Wilhelm

(57) **Zusammenfassung**

Die Erfindung betrifft eine Kühlanordnung, mit einer ersten und zumindest einer zweiten wärmeentwickelnden Computerkomponente, welche jeweils mit zumindest einem Kühlkörper (40, 50) gekoppelt ist. Die Kühlkörper (40, 50) sind in Richtung eines vorgesehenen Kühlluftstroms (30) in einer Ebene (10) nacheinander angeordnet. Die Kühlanordnung zeichnet sich dadurch aus, dass die Kühlkörper (40, 50) baugleich sind, und jeder Kühlkörper (40, 50) zumindest zwei nebeneinander liegende Bereiche (41, 42, 51, 52) mit voneinander verschiedenen Wärmeübergangseigenschaften umfasst. Zudem sind die Kühlkörper (40, 50) in der Ebene (10) derart zueinander gedreht angeordnet, dass die Bereiche (42, 52) der Kühlkörper (40, 50) mit einer jeweils höherer Wärmeübergangsleistung als der angrenzende Bereich (41, 51) in Richtung des Kühlluftstroms (30) nacheinander angeordnet sind.

## Beschreibung

Die Erfindung betrifft eine Kühlanordnung mit einer ersten und zumindest einer zweiten wärmeentwickelnden Computerkomponente, welche jeweils mit zumindest einem Kühlkörper gekoppelt ist. Dabei sind die Kühlkörper in Richtung eines vorgesehenen Kühlluftstroms in einer Ebene nacheinander angeordnet.

Computer umfassen zahlreiche verschiedenste elektrische, elektronische und integrierte Bauelemente, welche zur ihrer Funktion elektrische Energie benötigen. Teile dieser elektrischen Energie werden als Verlustenergie in nicht erwünschte Wärme gewandelt. Diese Wärme muss abgeführt werden, um Schäden durch eine Überhitzung an den Bauteilen zu vermeiden. Mit der fortschreitenden Entwicklung der Computer, werden diese elektrischen, elektronischen und integrierten Bauelemente, im Besonderen die integrierten Bauelemente und deren Schaltkreise, bei ansteigender Leistungsfähigkeit auch in ihrer räumlichen Ausdehnung kleiner. Damit einhergehend wird auch die Menge der Verlustenergie auf kleinerem Raum erhöht. Damit steigt zwangsläufig auch die Menge der unerwünschten Wärme, die abgeführt werden muss. Die Bedeutung einer effizienten Kühlung der wärmeentwickelnden Computerkomponenten hat damit zugenommen.

Zur Abfuhr der unerwünschten Wärme sind Kühlkörper bekannt. Kühlkörper sind aus festen Stoffen, wie zum Beispiel Aluminium gebildet und leiten unerwünschte Wärme von den elektrischen, elektronischen und integrierten Bauelementen an die Umgebungsluft ab.

Es ist aus der Druckschrift US 2008/0041562 A1 bekannt, zur Kühlung der wärmeentwickelnden Computerkomponenten eine Kühlanordnung vorzusehen, mit einer ersten und zumindest einer zweiten wärmeentwickelnden Computerkomponente, welche jeweils mit zumindest einem Kühlkörper gekoppelt ist. Dabei sind die Kühlkörper in Richtung eines vorgesehenen Kühlluftstroms in einer Ebene nacheinander angeordnet. Diese Anordnung bedingt, dass an dem in Richtung des Kühlluftstromes nachgeordneten Kühlkörper nur bereits durch den vorgeordneten Kühlkörper vorgewärmte Kühlluft zur Kühlung verfügbar ist. Demzufolge ist die erreichbare Kühlleistung an dem nachgeordneten Kühlkörper bei einer solchen Anordnung stets geringer als die Kühlleistung an dem vorgeordneten Kühlkörper. Um diesen Effekt zu kompensieren und dennoch auch an dem nachgeordneten Kühlkörper eine ausreichende Kühlung zu erreichen, ist in der Druckschrift US 2008/0041562 A1 vorgeschlagen, die Kühlleistung an dem nachgeordneten Kühlkörpern zu verbessern, indem ein Kühlluftstrom ausgebildet ist, welcher den ersten Kühlkörper und den zweiten Kühlkörper passiert und somit beide Kühlkörper nacheinander kühlt. Zusätzlich ist gemäß der Druckschrift US 2008/0041562 A1 vorgeschlagen, einen weiteren Kühlluftstrom auszubilden, welcher nur den nachgeordneten Kühlkörper kühlt. Alternativ zu dieser Maßnahme ist in der Druckschrift US 2008/0041562 A1 vorgeschlagen, den nachgeordneten Kühlkörper größer als den vorgeordneten Kühlkörper auszubilden und damit die Oberfläche des nachgeordneten Kühlkörpers gegenüber den vorgeordneten Kühlkörper zu vergrößern und so die Wärmeübergangseigenschaften des nachgeordneten Kühlkörpers zur Abgabe der Wärme an die Kühlluft gegenüber dem vorgeordneten Kühlkörper zu verbessern. Um die größere Oberfläche auszubilden werden gegenüber dem vorgeordneten Kühlkörper engere Abstände der Kühlrippen, oder höhere Kühlrippen vorgeschlagen.

Diese Lösung eignet sich die Kühleigenschaften des nachgeordneten Kühlkörpers zu verbessern, führt aber zu erhöhten Produktionskosten, da durch den geringeren Abstand zwischen den Kühlrippen eine höhere Anzahl von Kühlrippen gebildet ist, und auch mit einer Vergrößerung der Kühlrippen selbst des nachgeordneten Kühlkörpers zwangsläufig mehr Material und damit höhere Produktionskosten erforderlich sind.

Es ist daher die Aufgabe der Erfindung eine Lösung vorzuschlagen, mit welcher an beiden Kühlkörpern eine ausreichende Kühlleistung erzielbar ist, und dabei die Produktionskosten gegenüber den bekannten Maßnahmen verringerbar sind.

Diese Aufgabe wird durch die in den unabhängigen Patentansprüchen beschriebenen Maßnahmen gelöst. Dabei ist eine Kühlanordnung und ein Kühlverfahren zur Kühlung einer ersten und zumindest einer zweiten wärmeentwickelnden Computerkomponente, welche jeweils mit zumindest einem Kühlkörper gekoppelt ist, vorgeschlagen.
Die Kühlkörper sind in Richtung eines vorgesehenen Kühlluftstroms in einer Ebene nacheinander angeordnet. Die Lösung zeichnet sich gegenüber dem bekannten Stand der Technik dadurch aus, dass die Kühlkörper baugleich sind, und jeder Kühlkörper zumindest zwei nebeneinander liegende Bereiche mit voneinander verschiedenen Wärmeübergangseigenschaften, beziehungsweise Strömungswiderständen umfasst, wobei ein Bereich mit besseren Wärmeübergangseigenschaften, beziehungsweise höheren Strömungswiderständen und ein Bereich mit schlechteren Wärmeübergangseigenschaften, beziehungsweise geringeren Strömungswiderständen ausgebildet ist. Zudem sind die Kühlkörper um einen in der Ebene liegenden Punkt in der Ebene derart gedreht angeordnet, dass die Bereiche der Kühlkörper mit der jeweils schlechteren Wärmeübergangseigenschaft, beziehungsweise geringeren Strömungswiderständen in Richtung des Kühlluftstroms nacheinander angeordnet sind. Alternativ dazu sind die Kühlkörper in der Ebene derart zueinander versetzt angeordnet, nicht gedreht, dass im Wesentlichen nur dem Bereich mit den schlechteren Wärmeübergangseigenschaften, beziehungsweise geringeren Strömungswiderständen des vorgeordneten Kühlkörpers der Bereich mit den besseren Wärmeübergangseigenschaften, beziehungsweise höheren Strömungswiderständen des nachgeordneten Kühlkörpers in Richtung des vorgesehenen Kühlluftstroms nachgeordnet ist.

Zudem ist zumindest ein erster Kühlluftteilstrom erzeugt, welcher im Wesentlichen den Bereich mit den schlechteren Wärmeübergangseigenschaften, beziehungsweise geringeren Strömungswiderständen des vorgeordneten Kühlkörpers kühlt und in Richtung des vorgesehenen Kühlluftstroms einen der Bereiche des nachgeordneten Kühlkörpers kühlt. Aufgrund der schlechteren Wärmeübergangseigenschaften, beziehungsweise geringern Strömungswiderstände nimmt der erste Teilkühlluftstrom eine geringere Menge an Wärmeenergie auf, als ein nebenliegender zweiter Teilkühlluftstrom welcher den Bereich mit den besseren Wärmeübergangseigenschaften, beziehungsweise höheren Strömungswiderständen kühlt. Als Folge daraus ist das Temperaturniveau des ersten Teilkühlluftstroms beim Verlassen des vorgeordneten Kühlkörpers geringer als das Temperaturniveau des zweiten Teilkühlluftstroms. Damit ist mit dem ersten Teilkühlluftstrom am nachgeordneten Kühlkörper noch ausreichend kühle Kühlluft verfügbar um auch am nachgeordneten Kühlkörper noch ausreichende Kühlwirkung zu erzielen. Weiter ergibt sich damit dass mit dem zweiten Teilkühlluftstrom ein Teilkühlluftstrom erzeugt wird, der im Wesentlichen nur den Bereich mit den besseren Wärmeübergangseigenschaften, beziehungsweise höheren Strömungswiderständen des vorgeordneten Kühlkörpers kühlt.

Vorteilhaft an der Anordnung ist weiter, dass durch die Baugleichheit der Kühlkörper eine Einsparung der Produktionskosten auf zweifache Weise gegeben ist. Zum einen benötigt der nachgeordnete Kühlkörper nun nicht mehr Material als der vorgeordnete Kühlkörper. Zum anderen sind durch deren Baugleichheit ebenfalls die Produktionskosten reduzierbar, da Maschinen für die Produktion des baugleichen Kühlkörpers um das doppelte besser ausgelastet sind.

Die Wirksamkeit eines einzelnen Kühlkörpers lässt sich grundsätzlich mittels zweier physikalischer Größen beschreiben. Eine dieser physikalischen Größen ist die Wärmeleitfähigkeit eines Festkörpers, einer Flüssigkeit oder eines Gases und dessen Vermögen, thermische Energie mittels Wärmeleitung zu transportieren. Es wird die spezifische Wärmeleitfähigkeit als eine temperaturabhängige Materialkonstante von der absoluten Wärmeleitfähigkeit unterschieden. Dabei ist die absolute Wärmeleitfähigkeit eine von der Abmessung eines Bauteils abhängige Kennzahl. Die spezifische Wärmeleitfähigkeit ist von den Abmessungen des Bauteils unabhängig und ist eine Stoffkonstante des Stoffes, aus dem der Kühlkörper gebildet ist. Bezogen auf einen Kühlkörper beschreibt die Wärmeleitfähigkeit demzufolge die Eigenschaft des Kühlkörpers, die Wärme von einer ersten Übergangsfläche, zum Beispiel der Übergangsfläche, welche mit dem elektrischen, elektronischen oder integrierten Bauelement gekoppelt ist, zu einer zweiten Übergangsfläche zu leiten.

Eine weitere physikalische Größe zur Beschreibung der Wirksamkeit eines Kühlkörpers ist der Wärmeübergang von einem Festkörper auf einen mit diesem in Berührung stehenden gasförmigen oder flüssigen Körper. Der Wärmeübergang ist direkt proportional zur Größe der Übergangsfläche und zur Größe der Temperaturdifferenz zwischen beiden Körpern. Bezogen auf einen Kühlkörper beschreibt der Wärmeübergang demzufolge zum einen die Eigenschaft des Kühlkörpers, Wärme von dem mit dem Kühlkörper an der ersten Übergangsfläche gekoppelten elektrischen, elektronischen oder integrierten Bauelement aufzunehmen, und beschreibt zum anderen die Eigenschaft des Kühlkörpers, die Wärme an der zweiten Übergangsfläche an das umgebende Medium, zum Beispiel Luft abzugeben. Da der Wärmeübergang auch von der Temperaturdifferenz der beiden Körper direkt abhängig ist, wird mittels des Kühlluftstroms stets frische Kühlluft herangeführt, um das Temperaturniveau der Kühlluft nach Möglichkeit gering zu halten. Demzufolge transportiert der Bereich des Kühlkörpers mit schlechteren Wärmeübergangseigenschaften eine geringere Menge an Wärmeenergie an die den Kühlkörper umgebende Luft als der Bereich mit besseren Wärmeübergangseigenschaften.

Vorteilhaft an der vorgeschlagenen Anordnung ist, dass die Verbesserung des Wärmeübergangs an dem nachgeordneten Kühlkörper bei baugleichen Kühlkörpern erreicht wird, ohne dass die Strömungsgeschwindigkeit und damit die Luftmasse erhöht wird, welche die beiden Kühlkörper passiert.

Mittels Kühlrippen, welche wegen ihrer rippenförmigen Gestaltung so genannt werden, lässt sich auf einfache Weise die Oberfläche eines Körpers gegenüber einer ebenen Fläche vergrößern. Damit ist der Wärmeübergang an die Luft an der zweiten Oberfläche verbessert. Dabei sind die Kühlrippen eine Konstruktion aus wärmeleitendem Metall, zum Beispiel dem Metall des Kühlkörpers.

Eine vorteilhafte Weiterbildung der Erfindung sieht daher vor, die Kühlkörper mit Kühlrippen auszubilden, welche in deren längsgerichteter Ausdehnung parallel zu dem vorgesehenen Kühlluftstrom angeordnet sind. Damit ergibt sich der Vorteil, dass nicht nur die zweite Oberfläche des Kühlkörpers gegenüber einer ebenen Oberfläche vergrößert ist, sondern es ergeben sich durch die Kühlrippen verbesserte Strömungseigenschaften an den Kühlkörpern. Damit ist eine stetige Zufuhr von Kühlluft zu den Kühlkörpern gegeben.

Eine weitere vorteilhafte Weiterbildung sieht vor, dass Bereiche mit voneinander verschiedenen Wärmeübergangseigenschaften durch verschiedene Abstände der Kühlrippen gebildet sind. Der Bereich des Kühlkörpers mit den besseren Wärmeübergangseigenschaften als der nebenliegende Bereich wird somit dadurch gebildet, dass die Abstände zwischen den Kühlkörpern geringer ausgebildet werden. Damit werden eine größere Anzahl von Kühlrippen und damit eine größere zweite Oberfläche auf der Grundfläche des Kühlkörpers möglich. So wird Material bei der Produktion eingespart, da der Bereich des geringeren Wärmeübergangs gegenüber dem Bereich des höheren Wärmeübergangs eine kleinere Anzahl von Kühlrippen aufweist. Zudem wird damit ein durch die Kühlrippen bedingter Strömungswiderstand an den Bereichen mit unterschiedlich ausgebildeten Abständen ebenso unterschiedlich ausgebildet. Der Bereich mit den geringeren Abständen zwischen den Kühlrippen weist daher einen höheren Strömungswiderstand auf als der Bereich mit den größeren Abständen zwischen den Kühlrippen. Dies wirkt sich auch auf die Wärmeabgabe der der jeweiligen Bereiche aus. Der Bereich mit dem höheren Strömungswiderstand bewirkt eine bessere Wärmeabgabe an die Kühlluft.

Gemäß einer weiteren vorteilhaften Weiterbildung ist vorgesehen, dass der Kühlluftstrom mittels eines Lüfters erzeugt wird. Gegenüber einem Kühlluftstrom, welcher zum Beispiel durch natürliche Konvektion erzeugt wird, lässt sich ein Kühlluftstrom durch den Lüfter sehr schnell verändern. Damit ist eine schnelle Reaktion auf veränderte Umgebungsbedingungen möglich, denn die Förderleistung des Lüfters kann schnell erhöht werden, wogegen sich die Förderleistung eines durch natürliche Konvektion gebildeten Luftstromes nicht schnell beeinflussen lässt. Die gemäß dem obig beschriebenen Prinzip gebildete Anordnung erlaubt eine effiziente Kühlleistung an dem vorgeordneten Kühlkörper, ebenso wie an dem nachgeordneten Kühlkörper. Demzufolge muss alleine, um den nachgeordneten Kühlkörper mit ausreichender Kühlluft zu versorgen, gegenüber dem bekannten Stand der Technik die Förderleistung des Lüfters nicht erhöht werden. Demzufolge bleiben die Leistungsaufnahme und der Energieeinsatz, der erforderlich ist, die Wärme abzutransportieren, vergleichsweise gering. Ein weiterer Vorteil des vorstehend beschriebenen Prinzips ist, dass sich damit bei besserer Kühleigenschaft die Geräuschentwicklung zum Beispiel des Lüfters nicht erhöht. Dies wird zum einen dadurch erreicht, dass im Wesentlichen der Bereich geringeren Wärmeübergangs an beiden Kühlkörpern von einem Luftstrom nacheinander gekühlt wird, und an dem nachgeordneten Kühlkörper zudem ein Bereich gebildet ist, welcher von unerwärmter Kühlluft gekühlt wird.

Vorstehend ist die Erfindung in ihren prinzipiellen Eigenschaften und mit deren jeweiligen Vorteilen beschrieben. Nachfolgend ist die Erfindung mittels Ausführungsbeispielen unter der Zuhilfenahme von Figuren näher erläutert. Es zeigt die
Figur 1; ein Ausführungsbeispiel mit zueinander gedreht angeordneten Kühlkörpern, und die
Figur 2; ein Ausführungsbeispiel mit zueinander versetzt angeordneten Kühlkörpern.

Gleiche Teile sind in den verschiedenen Figuren mit gleichen Bezugszeichen versehen.

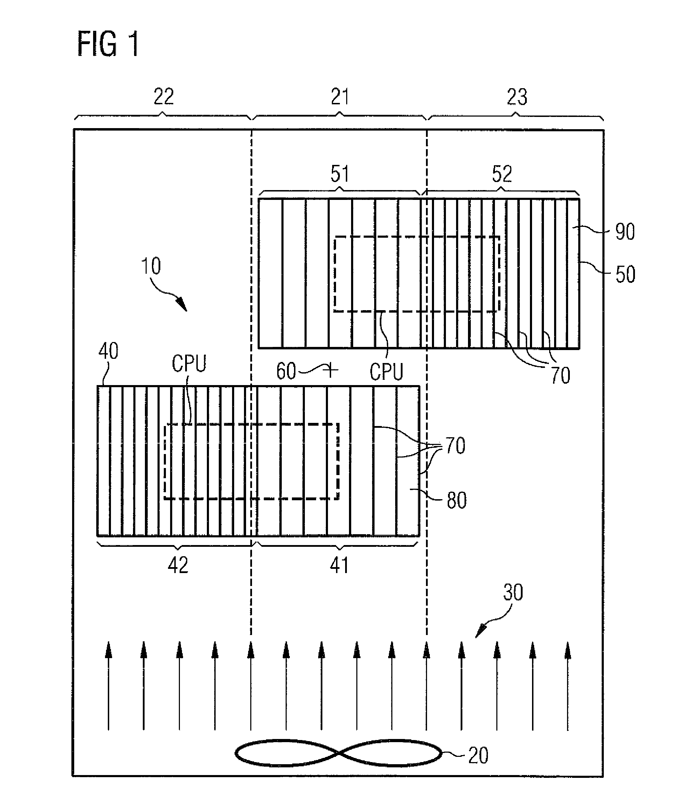

Es zeigt die Figur 1 eine schematische Darstellung zweier Kühlkörper angeordnet auf einer Ebene 10. Die Ebene 10 ist stellvertretend für zum Beispiel eine Computerhauptplatine, auf der im dargestellten Ausführungsbeispiel zwei integrierte Bauelemente (IC) wie zum Beispiel Computerhauptprozessoren CPU angeordnet sind.
Computerhauptprozessoren CPU sind zentrale Verarbeitungseinheiten eines Computers und weisen eine hohe Wärmeentwicklung auf. Computerhauptprozessoren CPU sind zumeist in quaderförmigen Gehäusen eingebettet. Diese quaderförmigen Gehäuse sind mit den Kühlkörpern thermisch gekoppelt. Das heißt, die quaderförmigen Gehäuse geben thermische Energie in Form von Wärme an die Kühlkörper ab.

Mittels eines Lüfters 20 wird ein Kühlluftstrom 30 erzeugt, der die Ebene 10 überstreicht. Auf der Ebene 10 ist ein in Richtung des Kühlluftstroms 30 vorgeordneter Kühlkörper 40 sowie ein in Richtung des Kühlluftstroms 30 nachgeordneter Kühlkörper 50 angeordnet. Der vorgeordnete Kühlkörper 40 ist baugleich mit dem nachgeordneten Kühlkörper 50. Jeder der beiden Kühlkörper 40, 50 weist zwei nebeneinander liegende Bereiche 41, 42 beziehungsweise 51, 52 mit voneinander verschiedenen Wärmeübergangseigenschaften auf. Der Bereich 41 des vorgeordneten Kühlkörpers 40 ist der Bereich mit den schlechten Wärmeübergangseigenschaften. Der Bereich 42 des vorgeordneten Kühlkörpers 40 ist der Bereich mit den besseren Wärmeübergangseigenschaften. Ebenso verhält es sich an dem Kühlkörper 50, dort ist der Bereich 51 der Bereich mit den schlechteren Wärmeübergangseigenschaften und der Bereich 52 ist der Bereich mit den besseren Wärmeübergangseigenschaften.

Die Kühlkörper 40, 50 sind um einen in der Ebene 10 liegenden Punkt 60 derart in der Ebene 10 gedreht angeordnet, dass die Bereiche 41, 51 der Kühlkörper 40, 50 mit den schlechteren Wärmeübergangseigenschaften in Richtung des vorgesehenen Kühlluftstroms 30 nacheinander angeordnet sind.

Zur Erläuterung ist der Kühlluftstrom 20 im Ausführungsbeispiel in drei Teilkühlluftströme 21, 22, 23 geteilt. Der erste Teilkühlluftstrom 21 kühlt den Bereich 41 des vorgeordneten Kühlkörpers 40 und den Bereich 51 des nachgeordneten Kühlkörpers 50. Der Bereich 41 des vorgeordneten Kühlkörpers 40 ist gegenüber dem Bereich 42 des vorgeordneten Kühlkörpers mit schlechteren Wärmeübergangseigenschaften ausgebildet. Im Ausführungsbeispiel der Figur 1 ist dies mittels einer geringeren Dichte an Kühlrippen 70 erreicht. Die geringere Dichte an Kühlrippen 70 ist dadurch gebildet, dass bei ungefähr gleicher Grundfläche der Bereiche 41 und 42 in dem Bereich 41 zwischen den Kühlrippen 70 ein erstes Abstandsmaß 80 vorgesehen ist, dessen Größe höher ist als ein zweites Abstandsmaß 90, welches zwischen den Kühlrippen des Bereichs 42 vorgesehen ist. Gleiches gilt für die Bereiche 51 und 52 des nachgeordneten Kühlkörpers 50. Damit weist der Bereich 42 des vorgeordneten Kühlkörpers 40 ebenso wie der Bereich 52 des nachgeordneten Kühlkörpers 50 verbesserte Wärmeübergangseigenschaften gegenüber den Bereichen 41 oder 51 der beiden Kühlkörper 40 und 50 auf. Zudem sind auch die Strömungswiderstände der Bereiche 41,42,51,52 verschieden. Die Bereiche 41 und 51 weisen aufgrund des höheren Abstandes zwischen den Kühlrippen 70 einen geringeren Strömungswiderstand gegenüber dem Kühlluftstrom auf als die Bereiche 42 und 52. Mittels der verbesserten Wärmeübergangseigenschaften der Bereiche 42 und 52 der beiden Kühlkörper wird an den beiden Kühlkörpern im Teilkühlluftstrom 21 eine ausreichende Kühlwirkung erzielt. Zudem sind die Teilkühlluftströme 22 und 23 an den Bereichen 41 beziehungsweise 51 der beiden Kühlkörper nicht durch einen vorgeordneten Kühlkörper vorgewärmt oder beschattet, so dass damit gute Strömungsverhältnisse in den Bereichen mit besseren Wärmeübergangseigenschaften erzielbar ist.

Im Ausführungsbeispiel erstrecken sich die Kühlrippen 70 in ihrer räumlichen Ausdehnung in Fließrichtung des Kühlluftstroms 30. Damit sind die Strömungsverhältnisse an den Kühlkörpern zusätzlich verbessert, wodurch die Effizienz der Kühlung zudem verbessert ist.

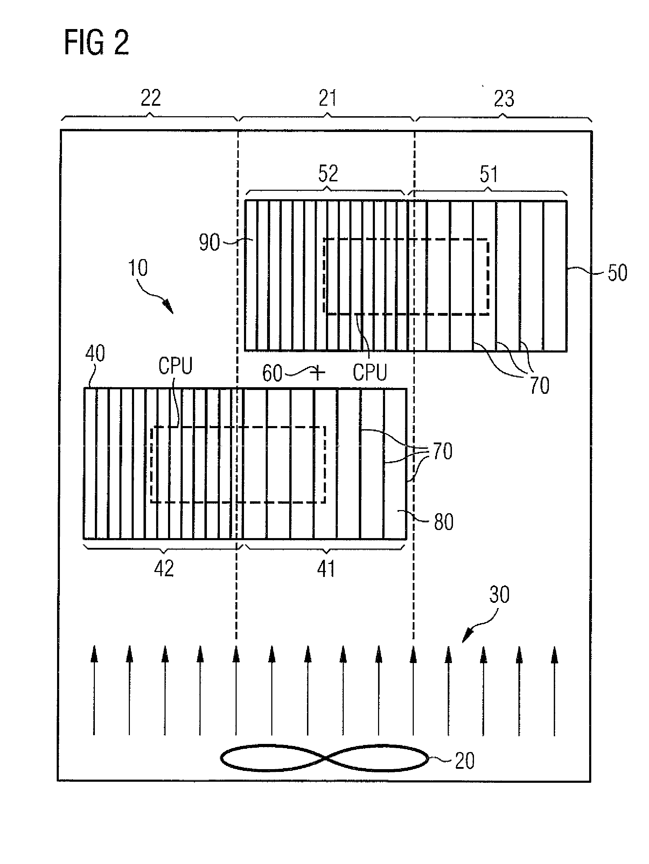

Es zeigt die Figur 2 eine schematische Darstellung eines Ausführungsbeispiels mit zwei Kühlkörpern angeordnet auf der Ebene 10. Auch bei diesem Ausführungsbeispiel wird mittels des Lüfters 20 der Kühlluftstrom 30 erzeugt, der die Ebene 10 überstreicht. Auf der Ebene 10 ist ein in Richtung des Kühlluftstroms 30 vorgeordneter Kühlkörper 40 sowie ein in Richtung des Kühlluftstroms 30 nachgeordneter Kühlkörper 50 angeordnet. Der vorgeordnete Kühlkörper 40 ist baugleich mit dem nachgeordneten Kühlkörper 50. Auch bei diesem Ausführungsbeispiel weißt jeder der beiden Kühlkörper 40, 50 zwei nebeneinander liegende Bereiche 41, 42 beziehungsweise 51, 52 mit voneinander verschiedenen Wärmeübergangseigenschaften auf. Der Bereich 41 des vorgeordneten Kühlkörpers 40 ist der Bereich mit den schlechten Wärmeübergangseigenschaften gegenüber dem Bereich 42 des vorgeordneten Kühlkörpers 40, der die besseren Wärmeübergangseigenschaften aufweist. Ebenso verhält es sich an dem Kühlkörper 50, dort ist der Bereich 51 der Bereich mit den schlechteren Wärmeübergangseigenschaften und der Bereich 52 ist der Bereich mit den besseren Wärmeübergangseigenschaften.

Die Kühlkörper 40, 50 sind in der Ebene 10 in Richtung des Kühlluftstroms 30 zueinander versetzt angeordnet. Die versetzte Anordnung ist so gewählt, dass von dem Teilkühlluftstrom 21 im Wesentlichen zuerst der Bereich 41 des vorgeordneten Kühlkörpers 40, und dann der Bereich 52 des nachgeordneten Kühlkörpers 50 überströmt wird.

Somit kühlt der erste Teilkühlluftstrom 21 den Bereich 41 des vorgeordneten Kühlkörpers 40 und den Bereich 52 des nachgeordneten Kühlkörpers 50. Der Bereich 41 des vorgeordneten Kühlkörpers 40 ist gegenüber dem Bereich 42 des vorgeordneten Kühlkörpers 40 mit schlechteren Wärmeübergangseigenschaften ausgebildet. Im Ausführungsbeispiel der Figur 2 ist dies mittels einer geringeren Dichte an Kühlrippen 70 erreicht, wodurch sich ein geringerer Strömungswiderstand ergibt. Mit dieser Maßnahme wird zum einen erreicht, das der Teilkühlluftstrom 21 am Bereich 41 des vorgeordneten Kühlkörpers weniger Wärmeenergie aufnimmt, und somit beim Überstreichen des Bereichs 52 des nachgeordneten Kühlkörpers 50 noch ausreichend Wärmeenergie aufnehmen kann um auch an diesem Bereich eine Kühlwirkung zu erzielen. Des Weiteren kühlt der Kühlluftteilstrom 22 den Bereich 42 des vorgeordneten Kühlkörpers 40 aufgrund der besseren Wärmeübergangseigenschaften, beziehungsweise höheren Strömungswiderstands dieses Bereichs stärker ab. Mittels der verbesserten Wärmeübergangseigenschaften, beziehungsweise des höheren Strömungswiderstands der Bereiche 42 und 52 der beiden Kühlkörper wird an den beiden Kühlkörpern in den jeweiligen Kühlluftteilströmen 21 und 22 eine ausreichende Kühlwirkung erzielt. So kühlt der Teilkühlluftstrom 22 nur den Bereich 42 der vorgeordneten Kühlkörpers 40, so dass die Erwärmung des Teilkühlluftstroms 22 keine nachteilige Wirkung auf nachfolgende Kühlkörper hat. Zudem kühlt der Teilkühlluftstrom 21 den Bereich 41 des vorgeordneten Kühlkörpers 40 leicht, und den Bereich 52 des nachgeordneten Kühlkörpers 50 stark. Der Teilkühlluftstrom 23 kühlt den Bereich 51 des nachgeordneten Kühlkörpers 50 ohne vorhergehende Erwärmung und erreicht damit an diesem Bereich 51 maximale Temperaturdifferenz zur Kühlung. Im Gesamten ergibt sich somit für beide Kühlkörper 40 und 50 eine optimale Kühlleistung.

Auch bei dem in Figur 2 dargestellten Ausführungsbeispiel erstrecken sich die Kühlrippen 70 in ihrer räumlichen Ausdehnung in Fließrichtung des Kühlluftstroms 30. Damit sind die Strömungsverhältnisse an den Kühlkörpern zusätzlich verbessert, wodurch die Effizienz der Kühlung zudem verbessert ist.

Für beide Ausführungsbeispiele gilt, dass durch die gedrehte oder versetzte Anordnung der beiden Kühlkörper 40 und 50 zueinander, ein Überdeckungsbereich gebildet ist. Dieser ist der Bereich, in dem der Kühlluftstrom 30 zuerst den vorgeordneten Kühlkörper 40 und dann den nachgeordneten Kühlkörper 50 überströmt. Durch den größeren Abstand der Kühlrippen 70 an dem Bereich 42 des vorgeordneten Kühlkörpers 40 steht an dem nachgeordneten Kühlkörper im Deckungsbereich mehr Kühlluft zur Verfügung. Optimale Strömungsverhältnisse an den Kühlkörpern sind dann gebildet, wenn der Strömungswiderstand des Bereichs 42 beziehungsweise 52 dem halben Wert des Strömungswiderstands des Bereichs 41 beziehungsweise 51 entspricht.

### Bezugszeichenliste

- 10: Ebene
- 20: Lüfter
- 21,22,23: Teilkühlluftströme
- 30: Kühlluftstrom
- 40: vorgeordneter Kühlkörper
- 50: nachgeordneter Kühlkörper
- 41/42: nebeneinander liegende Bereiche des vorgeordneten Kühlkörpers
- 51/52: nebeneinander liegende Bereiche des nachgeordneten Kühlkörpers
- 60: Punkt
- 70: Kühlrippen
- 80: erstes Abstandsmaß
- 90: zweites Abstandsmaß

## Patentansprüche

1. Kühlanordnung mit einer ersten und zumindest einer zweiten wärmeentwickelnden Computerkomponente, welche jeweils mit zumindest einem Kühlkörper (40, 50) gekoppelt ist, wobei die Kühlkörper (40, 50) in Richtung eines vorgesehenen Kühlluftstroms (30) in einer Ebene (10) nacheinander angeordnet sind,
**dadurch gekennzeichnet, dass**
die Kühlkörper (40, 50) baugleich sind, und jeder Kühlkörper (40, 50) zumindest zwei nebeneinander liegende Bereiche (41, 42, 51, 52) mit voneinander verschiedenen Wärmeübergangseigenschaften umfasst, und die Kühlkörper (40, 50) in der Ebene (10) derart zueinander gedreht oder versetzt angeordnet sind, dass im Wesentlichen nur dem Bereich (42) mit den schlechteren Wärmeübergangseigenschaften des vorgeordneten Kühlkörpers (40) einer der Bereiche (51, 52) des nachgeordneten Kühlkörpers in Richtung des vorgesehenen Kühlluftstroms (30) nachgeordnet ist.

2. Kühlanordnung nach Patentanspruch 1,
**dadurch gekennzeichnet, dass**
die Kühlkörper (40, 50) Kühlrippen (70) umfassen, welche in deren längsgerichteter Ausdehnung parallel zu dem vorgesehenen Kühlluftstrom (30) angeordnet sind.

3. Kühlanordnung nach Patentanspruch 2,
**dadurch gekennzeichnet, dass**
Bereiche (41, 42, 51, 52) mit voneinander verschiedener Wärmeleitfähigkeit durch verschiedene Abstände (90) der Kühlrippen (70) gebildet sind.

4. Kühlanordnung nach Patentanspruch 3,
**dadurch gekennzeichnet, dass**
der Kühlluftstrom (30) mittels eines Lüfters (20) erzeugt wird.

5. Verfahren mit einer ersten und zumindest einer zweiten wärmeentwickelnden Computerkomponente, welche jeweils mit einem Kühlkörper (40, 50) gekoppelt ist, wobei
ein Kühlluftstrom (30) vorgesehen ist, welcher den ersten und den zweiten Kühlkörper (40, 50) kühlt, und wobei die Kühlkörper (40, 50) in der Richtung des Kühlluftstroms (30) in einer Ebene (10) nacheinander angeordnet sind,
**dadurch gekennzeichnet, dass**
die zwei Kühlkörper (40,50) baugleich sind und jeweils nebeneinander liegende Bereiche (41, 42, 51, 52) mit voneinander verschiedener Wärmeübergangseigenschaft umfassen und derart nacheinander angeordnet sind, dass in der Strömungsrichtung des Kühlluftstroms (30) nur dem Bereich (41) mit der schlechteren Wärmeübergangseigenschaft des vorgeordneten Kühlkörpers (40) ein Bereich (51,52) des nachgeordneten Kühlkörpers (50) nachgeschaltet ist.

6. Verfahren nach Patentanspruch 5,
**dadurch gekennzeichnet, dass**
die Kühlkörper (40, 50) Kühlrippen (70) umfassen, welche in deren längsgerichteter Ausdehnung parallel zu dem vorgesehenen Kühlluftstrom (30) angeordnet sind.

7. Verfahren nach Patentanspruch 6,
**dadurch gekennzeichnet, dass**
Bereiche (41, 42, 51, 52) mit voneinander verschiedenen Wärmeübergangseigenschaften durch verschiedene Abstände (80, 90) der Kühlrippen gebildet sind.

8. Verfahren nach einem der Patentanspruche 4 bis 6
**dadurch gekennzeichnet, dass**
der Kühlluftstrom (30) mittels eines Lüfters (20) erzeugt wird.

9. Kühlanordnung mit einer ersten und zumindest einer zweiten wärmeentwickelnden Computerkomponente, welche jeweils mit zumindest einem Kühlkörper (40, 50) gekoppelt ist, wobei die Kühlkörper (40, 50) in Richtung eines vorgesehenen Kühlluftstroms (30) in einer Ebene (10) nacheinander angeordnet sind,
**dadurch gekennzeichnet, dass**
die Kühlkörper (40, 50) baugleich sind, und jeder Kühlkörper (40, 50) zumindest zwei nebeneinander liegende Bereiche (41, 42, 51, 52) mit voneinander verschiedenen Strömungswiderständen umfasst, und
die Kühlkörper (40, 50) in der Ebene (10) derart zueinander gedreht oder versetzt angeordnet sind, dass im Wesentlichen nur dem Bereich (42) mit den geringeren Strömungswiderständen des vorgeordneten Kühlkörpers (40) einer der Bereiche (51, 52) des nachgeordneten Kühlkörpers in Richtung des vorgesehenen Kühlluftstroms (30) nachgeordnet ist.

10. Kühlanordnung nach Patentanspruch 9,
**dadurch gekennzeichnet, dass**
die Kühlkörper (40, 50) Kühlrippen (70) umfassen, welche in deren längsgerichteter Ausdehnung parallel zu dem vorgesehenen Kühlluftstrom (30) angeordnet sind.

11. Kühlanordnung nach Patentanspruch 10,
**dadurch gekennzeichnet, dass**
Bereiche (41, 42, 51, 52) mit voneinander verschiedener Wärmeleitfähigkeit durch verschiedene Abstände (90) der Kühlrippen (70) gebildet sind.

12. Kühlanordnung nach Patentanspruch 11,
**dadurch gekennzeichnet, dass**
der Kühlluftstrom (30) mittels eines Lüfters (20) erzeugt wird.
